# FASCICULE DE BREVET EUROPEEN

(11) **EP 0 972 268 B1**
(45) Date de publication et mention de la délivrance du brevet: **15.05.2002**
(21) Numéro de dépôt: 98912559.6
(22) Date de dépôt: 27.02.1998
(51) Int. Cl.: G06K 19/077

(54) **PROCEDE DE FABRICATION DE CARTE SANS CONTACT AVEC CONNEXION D'ANTENNE PAR FILS SOUDES**
VERFAHREN ZUM HERSTELLEN KONTAKTLOSER KARTEN MIT ANTENNENVERBINDUNG DURCH GELÖTETE DRÄHTE
METHOD FOR MAKING A CONTACTLESS CARD WITH ANTENNA CONNECTED WITH SOLDERED WIRES

(30) Priorité: 25.03.1997 FR 9703630
(43) Date de publication de la demande: 19.01.2000
(73) Titulaire: GEMPLUS, 13881 Gémenos Cédex (FR)
(72) Inventeur: LAROCHE, Damien, F-13790 Chateauneuf le Rouge (FR); GARNIER, Pierre, F-83500 La Seyne sur Mer (FR)
(86) Numéro de dépôt international: FR9800383
(87) Numéro de publication internationale: WO9843205

(56) Documents cités:
- WO-A-93/18493
- WO-A-96/07985
- FR-A- 2 584 862

## Description

L'invention concerne la fabrication des cartes à puces, et plus particulièrement des cartes capables de fonctionner sans contact à l'aide d'une antenne intégrée dans la carte.

De telles cartes sont destinées à réaliser diverses opérations par exemple bancaires, communications téléphoniques, d'identification, de débit ou de rechargement d'unités de compte. Ces opérations s'effectuent à distance par couplage électromagnétique à haute fréquence entre une borne d'émission-réception et une carte placée dans la zone d'action de cette borne.

Un des problèmes techniques à résoudre dans la fabrication de telles cartes est la connexion de l'antenne à la puce de circuit intégré qui assure le fonctionnement électronique de la carte. Les contraintes de tenue mécanique, de fiabilité, et de coût de fabrication doivent évidemment être prises en compte dans cette fabrication.

Le document WO-A-9607985 décrit une technique connue pour connecter une antenne à une puce de circuit intégré consiste à déposer de petites gouttes de soudure appelées "bumps".

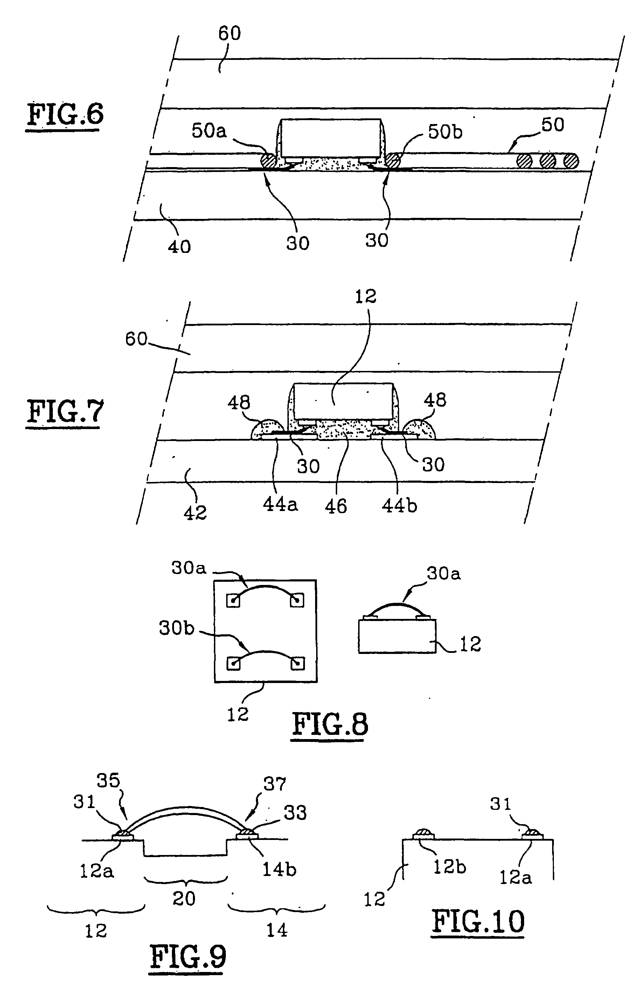

Le document WO-A-9318493 décrit une étiquette électronique RFID connectée à une antenne en fil de cuivre isolé, et dépourvu de substrat dit "lead frame". A cette fin, le retrait local de l'isolation autour du fil est obtenue par jet de gaz chaud. La connexion entre la puce et les fils de bobine prévoit pour porter une courte longueur dit tampon de la bobine, le rapprochement et le contact électrique. Sur la figure 7, une thermo compression est simultanée au portage effectué en déformant légèrement le fil de cuivre.

Le document FR-A-2584862 décrit la fabrication en continu de modules.

L'invention a pour objet de proposer un procédé de fabrication qui permet de résoudre au mieux le problème de la connexion électrique entre la puce et l'antenne.

L'invention propose à cet effet de fabriquer dans une première phase une puce de circuit intégré pourvue d'au moins une portion de fil conducteur soudé à la puce, ce fil ayant une partie en saillie par rapport à la surface de la puce, et de mettre ensuite en contact électrique, dans une deuxième phase, la puce et un conducteur d'antenne, en appliquant la partie en saillie sur une extrémité du conducteur d'antenne de manière à établir un contact électrique direct entre l'antenne et le fil soudé.

En d'autres mots, on utilise la technique très classique de "wire-bonding", ou soudage de fil par thermocompression, c'est-à-dire de soudage de fil (en général d'or ou d'aluminium) sur une puce, mais au lieu d'utiliser cette technique de la manière habituelle, c'est-à-dire en faisant partir un fil depuis un plot de contact de la puce pour l'amener jusqu'à un plot de contact d'un élément de support de puce (habituellement une grille de connexion ou un module de circuit imprimé), on soude une extrémité du fil sur un plot de contact de la puce mais on ne soude pas l'autre extrémité sur un élément extérieur sur lequel la puce serait reportée. Le fil reste libre pour servir d'élément de contact en saillie au-dessus de la puce.

L'invention propose par conséquent un procédé de fabrication de carte à puce sans contact tel que défini à la revandication 1.

Divers modes de mise en oeuvre de ce procédé sont envisageables. Dans une première réalisation, la première extrémité du fil soudé est soudée sur un plot de contact de la puce et la deuxième reste libre, de sorte que l'élasticité propre du fil facilite la mise en contact du fil et de l'antenne. Dans une autre réalisation, le fil est soudé sur deux plots de contact dé la puce, et la partie de fil située entre ces deux plots fait saillie au-dessus de la puce. Là encore, l'élasticité du fil facilite le contact avec le conducteur d'antenne. Dans une troisième réalisation, le fil est coupé très court au-dessus de la puce, de sorte qu'il ne reste pratiquement plus qu'une boule métallique écrasée sur le plot de contact (c'est-à-dire la boule classiquement formée par la tête de soudage de l'appareil de soudure par thermocompression), mais cette boule fait saillie suffisamment pour permettre un contact avec le conducteur d'antenne.

L'opération de soudage du fil conducteur se fait de préférence alors que la puce fait encore partie.d'une tranche qui sera ultérieurement découpée en puces individuelles (alors que la technique de "wire-bonding" classique pour la connexion avec un support extérieur est utilisée toujours sur une puce déjà découpée et prête à être montée dans un boîtier).

D'autres caractéristiques et avantages de l'invention apparaîtront à la lecture de la description détaillée qui suit et qui est faite en référence aux dessins annexés dans lesquels :
- la figure 1 représente une vue de dessus d'une tranche semiconductrice sur laquelle on a intégré une multiplicité de circuits électriques destinés à une carte à puce;
- la figure 2 représente en vue de dessus agrandie les puces juxtaposées sur la tranche, avec deux plots de contact par puce;
- la figure 3 représente, en vue de dessus les puces sur la tranche, avec des fils d'or qui relient les plots de contact de deux puces adjacentes par l'intermédiaire d'un plot de contact dans le chemin de découpe;
- la figure 4 représente une coupe latérale correspondant à la figure 3;
- la figure 5 représente les puces découpées avec des fils soudés faisant saillie et ayant une extrémité libre;
- la figure 6 représente le montage d'une puce dans une carte avec une connexion à une antenne bobinée;
- la figure 7 représente le montage d'une puce avec une antenne imprimée;
- la figure 8 représente une variante de réalisation dans laquelle chaque fil est soudé sur la puce en deux points;
- les figures 9 et 10 représente une autre variante de procédé dans laquelle les fils soudés sont coupés au ras de la boule formée par L'appareil de soudage de fils.

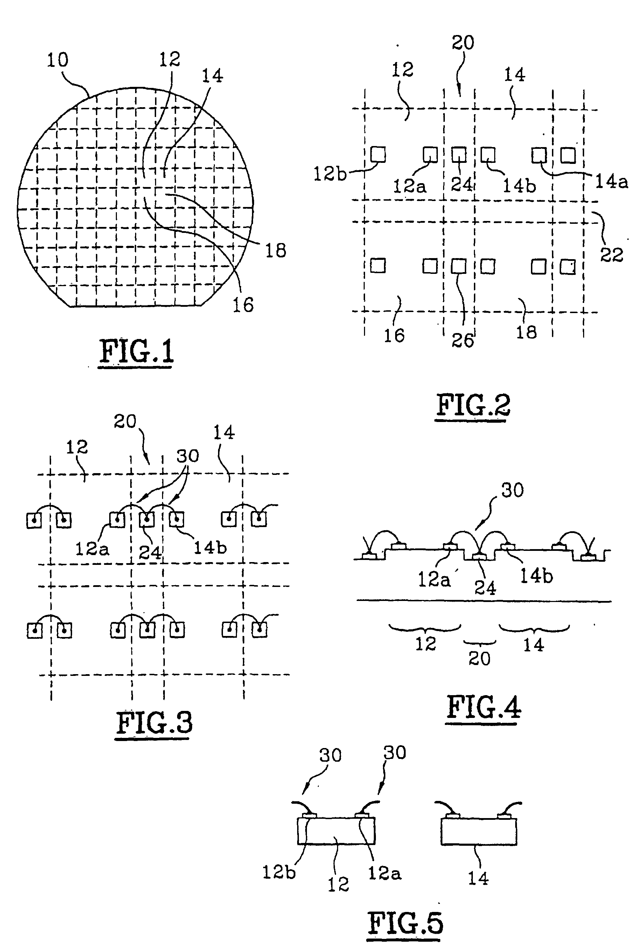

Sur la figure 1, on a représenté une tranche semiconductrice 10 sur laquelle ont été réalisés classiquement des circuits intégrés destinés à être séparés ultérieurement en puces individuelles. Les zones de découpe permettant de constituer des puces individuelles sont représentées en traits pointillés.

La figure 2 représente une vue agrandie avec quelques puces juxtaposées 12, 14, 16, 18, séparées par un chemin de découpe vertical 20 et un chemin de découpe horizontal 22.

Sur chaque puce on a prévu deux plots de contact permettant la soudure d'un fil d'or ou d'aluminium selon la technique classique du "wire-bonding". Les plots de contact sont désignés par l'indice a et b pour chaque puce, c'est-à-dire que la puce 12 comporte deux plots 12ₐ et 12_{b}. On a de préférence aussi prévu un plot de contact intermédiaire, placé dans un chemin de découpe entre deux puces adjacentes, ce plot étant situé entre deux plots immédiatement en regard appartenant chacun à une des deux puces adjacentes. Ainsi, le plot intermédiaire 24 est placé entre les plots 12a et 14b des puces 12 et 14 et le plot intermédiaire 26 est placé entre les plots 16a et 18b des puces 16 et 18. Ces plots ne sont pas obligatoires mais facilitent beaucoup le découpage ultérieur.

La figure 3 représente la mise en place de fils soudés selon la technique de "wire-bonding". Les fils sont des fils d'or en général mais peuvent aussi être en aluminium. Un fil 30 est soudé sur un plot (par exemple 12a) d'une puce et part vers le plot intermédiaire adjacent 24 qui sert de relais de maintien, il est soudé sur ce plot intermédiaire 24 et repart vers le plot 14b de la puce adjacente 14.

On rappelle que la technique classique de soudage de fils, dite "wire-bonding" et utilisée pour plus de 90% des circuits intégrés réalisés dans le monde, consiste à appliquer, à l'aide d'une tête de soudage, l'extrémité en boule d'un fil d'or ou d'aluminium contre un plot de la puce, à exercer une pression en présence de chaleur (soudage par thermocompression), et éventuellement en présence de vibrations ultrasoniques; puis à tirer le fil sans le couper, à l'aide de la tête de soudage, vers un autre point de soudure qui est en général, dans la technique connue, un plot d'un élément de support de la puce (grille ou circuit imprimé); puis à souder le fil sur ce deuxième plot de contact; et enfin à couper le fil immédiatement après cette deuxième opération de soudage, en laissant une boule de métal fondu à l'extrémité du fil en vue d'une nouvelle opération de soudage.

Dans la présente invention, l'opération de soudage consiste à souder le fil sur un plot d'une puce, à tirer le fil vers le plot intermédiaire, à souder le fil sur ce plot, et à repartir vers un plot d'une puce adjacente pour une nouvelle opération de soudure avant de couper le fil. L'opération globale de soudage de fil s'effectue donc sur la tranche semiconductrice avant découpage en puces individuelles.

La figure 4 représente en coupe le montage des fils. Le chemin de découpe 20 peut être constitué en creux par rapport à la surface supérieure des puces compte tenu des opérations de dépôt et gravure qui ont été effectuées sur la tranche préalablement aux opérations de soudure de fils.

L'opération suivante est le découpage de la tranche en puces individuelles. Ce découpage se fait en principe par sciage, et les fils soudés sont coupés lors de cette opération. La largeur du trait de sciage est elle du chemin de découpe 20. Les plots intermédiaires 24, 26, situés dans ce chemin, disparaissent lors du sciage, mais ils présentent l'intérêt de maintenir les fils pendant L'opération de sciage des puces. Le sciage des fils en est facilité. La figure 5 représente en coupe latérale les puces résultant de ce sciage : les fils 30 ont été coupés. et leurs extrémités restent libres.

Les puces peuvent alors être montées dans une carte sans contact comportant une antenne. L'antenne pourra être constituée soit par un fil conducteur bobiné soit par un conducteur imprimé sur une feuille ou une plaquette isolante.

Dans le premier cas, représenté à la figure 6, on peut procéder ainsi : on colle la puce 12 avec ses fils d'or 30 contre la surface d'une feuille ou d'une plaquette de matière plastique 40 au format de la carte qu'on veut réaliser. La colle est une colle non-conductrice. C'est la face avant, active de la puce, c'est-à-dire celle qui porte les plots de contact et les fils d'or, qui est appliquée contre cette surface. Les extrémités des fils soudés 30 dépassent des bords de la puce en raison de leur élasticité.

Puis on met en place et on colle l'antenne en fil bobiné 50 sur la feuille de matière plastique 40 de manière que les extrémités 50a, 50b de l'antenne bobinée viennent s'appliquer contre les fils soudés 30 et établissent un contact électrique direct entre le fil bobiné d'antenne (qui peut être en cuivre) et les fils soudés. Le maintien du contact peut alors être fait soit par collage avec une goutte de colle conductrice soit par soudure à l'étain entre le fil d'or et le fil de cuivre.

Une deuxième feuille de matière plastique 60 peut alors être appliquée au-dessus de l'ensemble ainsi réalisé et fixée par collage ou par laminage à chaud ou à froid, pour enfermer la puce et l'antenne et constituer ainsi la carte sans contact.

Si l'antenne est réalisée sous forme d'un conducteur imprimé sur un substrat isolant, le montage est fait comme cela est représenté à la figure 7 : le substrat isolant est par exemple une feuille de matière plastique 42 (PVC notamment) revêtue d'une couche métallique sérigraphiée ou gravée à la forme de l'antenne. Les extrémités 44a, 44b du conducteur d'antenne sont séparées d'une distance qui correspond sensiblement à la distance entre les extrémités libres des fils soudés 30 de la puce. On colle la puce avec une colle non-conductrice 46, face avant vers la face métallisée de la feuille 42, de telle sorte que les fils soudés sur la puce s'appliquent contre les extrémités du conducteur d'antenne; la colle non-conductrice ne doit pas être appliquée de manière à empêcher la mise en contact électrique entre fils soudés et antenne. Une colle conductrice 48 peut être appliquée ensuite sur les fils soudés pour assurer le maintien du contact électrique. Une deuxième feuille de matière plastique 60 est ensuite rapportée par collage ou laminage à chaud ou à froid pour enfermer la puce et constituer la carte sans contact.

Dans les réalisations des figures 6 et 7, la tranche de la puce est de préférence revêtue de colle non-conductrice ou d'un autre revêtement isolant (vernis ou autre) pour que la colle conductrice ne vienne pas établir des contacts indésirables entre le fil d'antenne et la puce.

D'une manière générale, dans toutes les réalisations décrites, on peut envisager l'utilisation de colles à conduction anisotrope à la place des colles conductrices et non-conductrices, les colles à conduction anisotrope ayant la particularité de conduire dans le sens de l'épaisseur de la couche de colle mais pas dans le sens du plan de la couche. Dans ce cas, une colle à conduction anisotrope peut remplacer à la fois la colle conductrice et la colle non-conductrice, pour permettre de réaliser le collage en une seule étape plutôt que deux sans risquer de courts-circuits indésirables.

Dans une variante de réalisation représentée à la figure 8 en vue de face et vue latérale, les fils qui sont soudés sur la puce et qui vont servir à établir le contact n'ont pas d'extrémité libre coupée : les deux extrémités de chaque fil sont soudées sur deux plots de contact séparés sur la puce, et c'est la partie saillante du fil entre les deux extrémités qui va établir le contact. Lors du sciage des puces, les fils ne se situent pas dans le chemin de découpe et ne sont donc pas coupés. Il n'est pas nécessaire de prévoir des plots de contact intermédiaires dans les chemins de découpe. Il est d'ailleurs possible dans ce cas de souder les fils d'or ou d'aluminium avant sciage ou après sciage de la tranche semiconductrice en puces individuelles.

Cette réalisation de la figure 8 se prête mieux à une connexion avec une antenne imprimée qu'à une connexion avec une antenne en fil bobiné. La méthode de fixation entre l'antenne et la puce est de préférence une soudure à l'étain plutôt qu'un collage par une colle conductrice qui poserait plus de problèmes de risques de contacts indésirables. Une colle anisotrope est bien adaptée également à ce cas.

Dans les différentes réalisations décrites ci-dessus, on peut prévoir avantageusement qu'une goutte de résine de protection et de maintien est déposée sur la face avant de la puce. Cette résine permet en particulier un meilleur maintien des fils soudés dans les opérations de sciage et de montage ultérieur. La goutte est donc de préférence déposée sur chaque puce avant sciage de la tranche.

Dans une autre variante de réalisation, on n'utilise pas de plot de contact intermédiaire dans le chemin de découpe entre les puces. Le fil d'or est relativement tendu entre un plot d'une puce et le plot en regard sur la puce adjacente. Etant donné que l'opération de soudure de fil sur un plot de contact crée une boule de soudure sur le plot et une zone de fil fragilisée juste au-dessus de la boule, l'opération de sciage des puces rompt le fil juste au-dessus de la boule qui reste seule sur le plot.

La figure 9 représente, en vue transversale encore plus agrandie le fil 30 qui relie le plot 12a d'une puce 12 et le plot 14b d'une puce adjacente 14, au-dessus du chemin de découpe. Le fil soudé forme une boule 31, 33 sur chaque plot de contact, et une zone fragilisée 35, 37 juste au-dessus de la boule.

La figure 10 représente les puces 12 et 14 après sciage, comportant des fils soudés par "wire-bonding", constitués uniquement par des boules d'or ou d'aluminium telles que 31. La puce est collée sur les extrémités du conducteur d'antenne, de préférence par une colle à conduction anisotrope.

## Revendications

1. Procédé de fabrication de carte à puce sans contact, comportant une puce de circuit intégré (12) et une antenne (50), **caractérisé en ce que** dans une étape préliminaire on soude par la technique du "wire-bonding" au moins un fil conducteur (30) entre un plot de contact (12a) de la puce et un autre plot de contact (14b; 24), et on établit, dans une étape ultérieure, un contact électrique direct entre au moins une partie du fil conducteur soudé (30) encore soudée audit plot de contact de la puce et une extrémité (50a, 50b) d'un conducteur d'antenne.

2. Procédé selon la revendication 1, **caractérisé en ce que** le fil conducteur soudé sur le plot de contact possède une partie en saillie par rapport à la surface de la puce, et **en ce que** lors de l'étape de mise en contact électrique entre le fil soudé et l'extrémité du conducteur d'antenne on applique la partie en saillie sur cette extrémité.

3. Procédé selon l'une des revendications 1 ou 2, **caractérisé en ce que** le fil conducteur (30) est soudé pendant que la puce fait encore partie d'une tranche semiconductrice (10) dans laquelle des puces seront ultérieurement formées par sciage.

4. Procédé selon la revendication 3, **caractérisé en ce que** le fil est soudé entre un plot de contact (12a) d'une puce (12) et un plot de contact (14b) d'une puce adjacente (14) sur la tranche.

5. Procédé selon la revendication 4, **caractérisé en ce que** le fil (30) est soudé entre les plots (12a, 14b) de deux puces adjacentes, par l'intermédiaire d'un plot supplémentaire (24) prévu dans un chemin de découpe entre les puces.

6. Procédé selon l'une des revendications 3 à 5, **caractérisé en ce que** le fil (30) est coupé pendant une opération de sciage dans laquelle on découpe la tranche en puces élémentaires, une extrémité de fil restant libre et en saillie au-dessus de la puce alors que l'autre extrémité du fil est soudée sur un plot de contact de la puce.

7. Procédé selon l'une des revendications 1 à 3, **caractérisé en ce que** le fil est soudé entre deux plots de contact d'une même puce, la partie de fil située entre les deux plots faisant saillie au dessus de la puce.

8. Procédé selon l'une des revendications 1 à 3, **caractérisé en ce que** le fil est soudé entre deux puces adjacentes et est coupé lors de l'opération de sciage juste au-dessus d'une boule (31, 33) soudée sur un plot de contact de la puce, la boule faisant saillie au-dessus de la surface de la puce pour permettre un contact avec une extrémité de conducteur d'antenne.

9. Procédé selon l'une des revendications 1 à 8, **caractérisé en ce que** la puce pourvue d'un fil soudé est collée sur une feuille de matière plastique (40), et une antenne en fil bobiné est collée sur cette feuille, une extrémité au moins (50a, 50b) du fil d'antenne étant appliquée contre le fil soudé de la puce.

10. Procédé selon l'une des revendications 1 à 8, **caractérisé en ce que** la puce pourvue d'un fil soudé est collée sur une feuille de matière plastique (42) portant un conducteur d'antenne imprimé, le fil soudé étant appliqué contre une extrémité du conducteur d'antenne.

## Patentansprüche

1. Herstellungsverfahren von kontaktlosen Chipkarten, mit einem IC-Chip (12) und einer Antenne (50), **dadurch gekennzeichnet, dass** man in einer ersten Etappe per « wire-bonding »-Technik mindestens einen Leiter (30) zwischen einem Kontaktstift (12a) des Chips und einem anderen Kontaktstift (14b ; 24) verschweißt, und man in einer nachfolgenden Etappe einen direkten elektrischen Kontakt zwischen mindestens einem Teil des verschweißten Leiters (30) , ebenfalls am besagten Kontaktstift des Chips verschweißt, und einem Ende (50a, 50b) eines Antennenleiters herstellt.

2. Verfahren nach Anspruch 1, **dadurch gekennzeichnet, dass** der am Kontaktstift verschweißte Leiter einen in Bezug auf die Oberfläche des Chips hinausragenden Teil aufweist, und dass man bei der Herstellungsetappe des elektrischen Kontakts zwischen dem verschweißten Leiter und dem Ende des Antennenleiters den hinausragenden Teil gegen dieses Ende drückt.

3. Verfahren nach einem der Ansprüche 1 und 2, **dadurch gekennzeichnet, dass** der Leiter (30) verschweißt wird, während der Chip noch Bestandteil einer Halbleiterscheibe (10) ist, aus der die Chips später durch Aussägen gebildet werden.

4. Verfahren nach Anspruch 3, **dadurch gekennzeichnet, dass** der Leiter zwischen einem Kontaktstift (12a) eines Chips (12) und einem Kontaktstift (14b) eines auf der Scheibe benachbarten Chips (14) verschweißt wird.

5. Verfahren nach Anspruch 4, **dadurch gekennzeichnet, dass** der Leiter (30) über einen zusätzlichen, auf einem Schnittweg zwischen den Chips vorgesehenen Stift (24) zwischen den Stiften (12a, 14b) zweier benachbarter Chips versohweißt wird.

6. Verfahren nach einem der Ansprüche 3 bis 5, **dadurch gekennzeichnet, dass** der Leiter (30) während einer Sägeoperation abgeschnitten wird, bei der man die Scheibe in elementare Chips ausstanzt, wobei ein Leiterende frei bleibt und über den Chip hinausragt, während das andere Ende des Leiters an einem Kontaktstift des Chips verschweißt wird.

7. Verfahren nach einem der Ansprüche 1 bis 3, **dadurch gekennzeichnet, dass** der Leiter zwischen zwei Kontaktstiften eines gleichen Chips verschweißt wird, wobei der zwischen den beiden Stiften angeordnete Leiter über den Chip hinausragt.

8. Verfahren nach einem der Ansprüche 1 bis 3, **dadurch gekennzeichnet, dass** der Leiter zwischen zwei benachbarten Chips verschweißt wird und bei der Sägeoperation etwas über einer an einem Kontaktstift des Chips verschweißten Kugel (31, 33) abgeschnitten wird, wobei die Kugel Über die Oberfläche des Chips hinausragt, um einen Kontakt mit einem Ende des Antennenleiters zu ermöglichen.

9. Verfahren nach einem der Ansprüche 1 bis 8, **dadurch gekennzeichnet, dass** der mit einem verschweißten Leiter versehene Chip auf eine Kunststofffolie (40) geklebt wird und dass eine Antenne aus gewickeltem Draht auf diesen Film geklebt wird, wobei mindestens ein Ende (50a, 50b) des Antennendrahts gegen den verschweißten Leiter des Chips anliegt.

10. Verfahren nach einem der Ansprüche 1 bis 8, **dadurch gekennzeichnet, dass** der mit einem verschweißten Leiter versehene Chip auf eine Kunststofffolie (40) geklebt wird, die einen gedruckten Antennenleiter trägt, wobei der verschweißte Leiter gegen ein Ende des Antennenleiters anliegt.

## Claims

1. A method for manufacturing a contactless smart card, having an integrated circuit chip (12) and an antenna (50), **characterised in that**, in a preliminary step, at least one conductive wire (30) is bonded, by the so-called "wire bonding" technique, between a contact pad (12a) of the chip and another contact pad (14b; 24) and, in a subsequent step, a direct electrical contact is established between at least one part of the conductive wire (30) still bonded to said contact pad of the chip and one end (50a, 50b) of an antenna conductor.

2. A method according to Claim 1, **characterised in that** the conductive wire bonded onto the contact pad has part projecting with respect to the surface of the chip, and **in that**, during the step of making electrical contact between the bonded wire and the end of the antenna conductor, the projecting part is applied onto this end.

3. A method according to either of Claims 1 or 2, **characterised in that** the conductive wire (30) is bonded while the chip still forms part of a semiconductor wafer (10) from which chips will subsequently be formed by sawing.

4. , A method according to Claim 3, **characterised in that** the wire is bonded between a contact pad (12a) of a chip (12) and a contact pad (14b) of an adjacent of a chip (12) and a contact pad (14b) of an adjacent chip (14) on the wafer.

5. A method according to Claim 4, **characterised in that** the wire (30) is bonded between the pads (12a, 14b) of two adjacent chips, by means of an additional pad (24) provided in a cutting path between the chips.

6. A method according to one of Claims 3 to 5, **characterised in that** the wire (30) is cut during a sawing operation in which the wafer is cut into elementary chips, one wire end remaining free and projecting above the chip while the other end of the wire is bonded onto a contact pad of the chip.

7. A method according to one of Claims 1 to 3, **characterised in that** the wire is bonded between two contact pads of the same chip, the part of the wire situated between the two pads projecting above the chip.

8. A method according to one of Claims 1 to 3, **characterised in that** the wire is bonded between two adjacent chips and is cut during the sawing operation just above a ball (31, 33) bonded onto a contact pad of the chip, the ball projecting above the surface of the chip in order to allow a contact with one antenna conductor end.

9. A method according to one of Claims 1 to 8, **characterised in that** the chip provided with a bonded wire is glued onto a sheet of plastic material (40), and a wound wire antenna is glued onto this sheet, at least one end (50a, 50b) of the antenna wire being applied against the bonded wire of the chip.

10. A method according to one of Claims 1 to 8, **characterised in that** the chip provided with a bonded wire is glued onto a sheet of plastic material (42) carrying a printed antenna conductor, the bonded wire being applied against one end of the antenna conductor.
